# DEMANDE DE BREVET EUROPEEN

(11) **EP 2 190 061 A1**
(43) Date de publication de la demande: **26.05.2010**
(21) Numéro de dépôt: 09175384.8
(22) Date de dépôt: 09.11.2009
(51) Int. Cl.: H01Q 1/24, H01P 1/04, H01L 23/498

(54) **Réseau d'éléments rayonnant, et antenne comportant un tel réseau**

(30) Priorité: 25.11.2008 FR 0806613
(71) Demandeur: Thales, 92200 Neuilly Sur Seine (FR)
(72) Inventeur: Touchard, Sylvie, 91410 Dourdan (FR)
(74) Mandataire: Lucas, Laurent Jacques

(57) **Abrégé**

La présente invention concerne un réseau d'éléments rayonnant. Elle concerne également une antenne comportant un tel réseau.

Les éléments rayonnant (1), fixés sur un support (30), sont réalisés en technologie à réseau de billes (21, 22) dite BGA, un élément rayonnant comprenant un substrat diélectrique (32) comportant en face avant une surface métallisée (31) et en face arrière deux séries de billes, une première série comportant au moins une bille de signal (22) reliée électriquement à la surface métallisée (31) apte à recevoir un signal hyperfréquence et la deuxième comportant un réseau de billes de masse (31) entourant les billes de la première série, lesdites billes (31) de la deuxième série étant connectées à un plan de masse (33) du support.

Application : antennes à balayage électronique.

## Description

La présente invention concerne un réseau d'éléments rayonnant. Elle concerne également une antenne comportant un tel réseau.
Les antennes à balayage électronique sont couramment constituées d'un ensemble d'éléments rayonnant émettant une onde hyperfréquence dont la phase est électroniquement commandable, indépendamment pour chaque élément ou groupe d'éléments. L'orientation du faisceau d'antenne est fonction des différents déphasages appliqués à chacun des éléments rayonnant.
Une solution connue pour réaliser un réseau d'éléments rayonnant est la technique du circuit imprimé où les éléments rayonnant sont des pastilles conductrices généralement appelées « patch ». Les lignes d'alimentation hyperfréquence ainsi que d'autres circuits d'émission ou de réception, tels que les circuits de filtrage et d'interface avec les voies d'émission ou réception par exemple, peuvent être intégrés dans ces circuits imprimés réalisés alors en plusieurs couches.
Il est connu que les performances de dépointage du faisceau d'antenne, c'est-à-dire de commande de l'orientation du faisceau, sont liées au couplage entre ces éléments rayonnant. Plus le couplage est important, plus les performances sont dégradées. Par ailleurs, le coût d'une telle antenne à réseau d'éléments rayonnant est essentiellement due à sa réalisation complexe intégrant des éléments hyperfréquence. La technologie de circuits imprimés appliquée aux antennes impose des tailles et épaisseurs maximales standards des matériaux utilisés.
Dans les solutions existantes, les fonctions de rayonnement, filtrage, calibration et interface sont séparées ou intégrées dans un ensemble compact. Lorsque ces fonctions sont séparées, elles nécessitent une structure lourde et coûteuse, ainsi qu'une maintenance complexe. La compacité est possible mais néanmoins restreinte du fait de l'épaisseur de ces antennes imposée par la taille standard des circuits imprimés. Enfin dans une solution compacte à circuit imprimé, le couplage entre éléments rayonnant est important et il en résulte de médiocres performances au niveau du dépointage du faisceau d'antenne.

Un but de l'invention est notamment de réduire le couplage entre éléments rayonnant dans un réseau tout en réduisant l'encombrement des fonctions hyperfréquences.
A cet effet, l'invention a pour objet un réseau d'éléments rayonnant, les éléments rayonnant, fixés sur un support, étant réalisés en technologie à réseau de billes dite BGA, un élément rayonnant comprenant un substrat diélectrique comportant en face avant une surface métallisée et en face arrière deux séries de billes, une première série comportant au moins une bille de signal reliée électriquement à la surface métallisée apte à recevoir un signal hyperfréquence et la deuxième comportant un réseau de billes de masse entourant les billes de la première série, lesdites billes de la deuxième série étant connectées à un plan de masse du support.
Les billes de masse sont par exemple alignées à la périphérie de la face arrière du substrat.
la distance entre deux billes de masse consécutives est, par exemple, telle que l'ensemble des billes de masse forme un blindage électromagnétique pour les billes de signal.
Le support est, par exemple, un circuit imprimé.
Les billes de masse étant connectées à un plan de masse du circuit imprimé, les billes de signal peuvent être connectées à une piste interne du circuit imprimé apte à guider un signal hyperfréquence, via une ligne transversale.
Le circuit imprimé est, par exemple, du type triplaque.
Selon un mode de réalisation, le circuit imprimé comporte des composants réalisant des fonctions hyperfréquence appliquées aux signaux transitant par les billes de signal.
Le circuit imprimé peut comporter les fonctions de filtrage, de calibration et de routage des signaux hyperfréquence vers les éléments rayonnant.
Le réseau d'éléments rayonnant formant une première structure, cette première structure est recouverte d'une deuxième structure comportant des éléments rayonnant sensiblement alignés sur les éléments rayonnant de la première structure.
L'invention concerne aussi une antenne comportant un réseau présentant une ou plusieurs caractéristiques précitées.

L'invention a encore pour avantage qu'elle est économique car permettant de réaliser des antennes à faible coût.
D'autres caractéristiques et avantages de l'invention apparaîtront à l'aide de la description qui suit faite en regard de dessins annexés qui représentent :
- la figure 1, un exemple d'antenne à réseau d'éléments rayonnant selon l'invention par une vue de dessus ;
- la figure 2, un exemple de réalisation d'éléments rayonnant composant un réseau dans une antenne selon l'invention ;
- la figure 3, par une vue en coupe un premier exemple d'une antenne selon l'invention ;
- la figure 4, par une vue en coupe un autre exemple de réalisation d'une antenne selon l'invention.

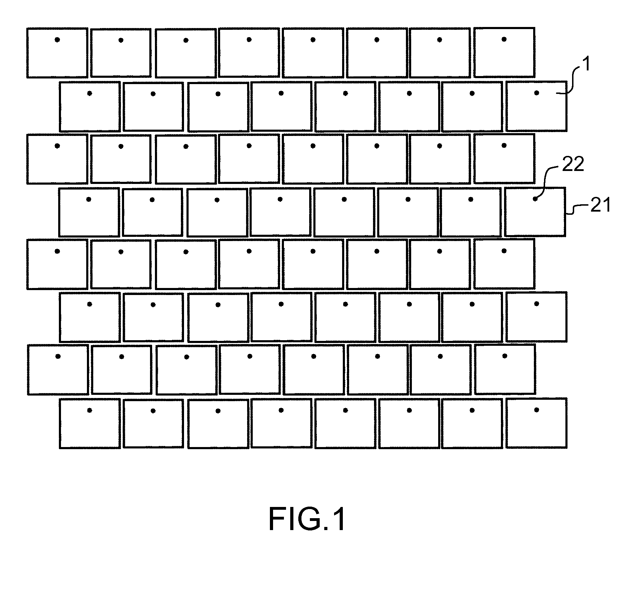

La figure 1 présente un exemple d'antenne à réseau d'éléments rayonnant selon l'invention. Plus particulièrement, la figure 1 présente l'ensemble des éléments rayonnant 1 formant le réseau. Les éléments rayonnant 1 sont des pastilles métalliques encore appelées « patch », de forme sensiblement carrée. Ils sont disposés en ligne, deux lignes consécutives étant décalées l'une par rapport à l'autre d'une demi-longueur de « patch ». Leur source d'alimentation peut être unique, pour obtenir une polarisation linéaire horizontale ou verticale, ou multiple pour obtenir par exemple une polarisation circulaire à deux ou plusieurs accès. Selon l'invention, chaque élément rayonnant est formé d'un patch en technologie BGA. La connexion des composants est assurées par un réseau de billes métalliques disposés en face arrière, d'où le terme BGA issu de l'expression anglo-saxonne « Ball Grid Array », les billes métalliques étant au contact par exemple des pistes conductrices d'un circuit imprimé.

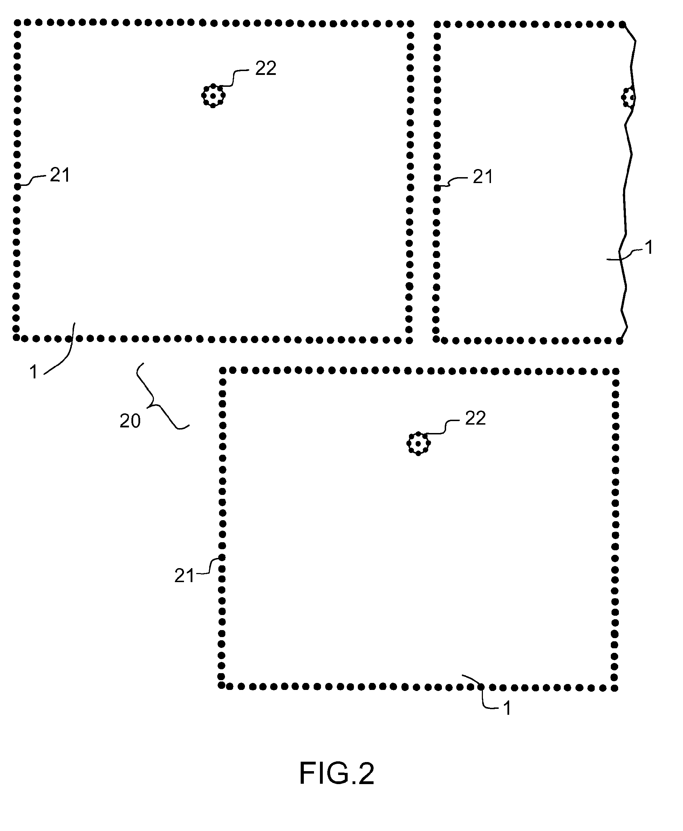

La figure 2 illustre de façon schématique un exemple de réalisation d'éléments rayonnant 1 utilisés dans un réseau selon l'invention. Chaque élément rayonnant est réalisé en technologie BGA et fixé au circuit imprimé supportant le réseau au moyen de billes.
Plus particulièrement un élément rayonnant 1 comporte un substrat en matériau diélectrique sur lequel est implanté en face avant une surface métallisée formant la fonction rayonnante et sur lequel est implanté en face arrière des billes 21, 22. Des billes permettent de véhiculer un signal hyperfréquence jusqu'à la surface rayonnante, ce signal hyperfréquence étant amené par une du circuit imprimé sur lequel est implanté l'élément rayonnant. A cet effet, ces billes 22 disposées à l'intérieur de face arrière sont reliées par une ligne conductrice, traversant le substrat, à la surface rayonnante. Une autre série de billes 21 sont reliées par exemple à un potentiel de masse. Ces billes 21 sont par exemple alignées à la périphérie de la face arrière de l'élément rayonnant.
Ainsi, chaque élément rayonnant possède des billes de masse 21 pour le contact de masse de l'élément rayonnant avec la masse du circuit imprimé ainsi qu'une ou plusieurs billes de signal 22. En particulier, il peut comporter une seule bille si la polarisation est linéaire ou plusieurs billes si la polarisation est circulaire. La figure 2 illustre un cas à plusieurs billes de signal 22, une bille centrale étant entourée de plusieurs billes disposées en cercle. Cette alimentation de la surface rayonnante par bille de signal 22 entourées de billes de masse 21 est similaire à une alimentation par sonde ou câble coaxial. Le blindage est optimal car les billes de masse entourent la ou les billes de signal pour chaque élément rayonnant. Un double blindage 20 est notamment réalisé entre deux éléments rayonnant consécutifs car utilisant deux rangées de billes de masses juxtaposées.
Ceci présente notamment l'avantage de réduire considérablement le couplage entre éléments rayonnant et d'éviter la propagation de modes parasites dans le substrat diélectrique sur lequel sont gravées les surfaces rayonnantes.

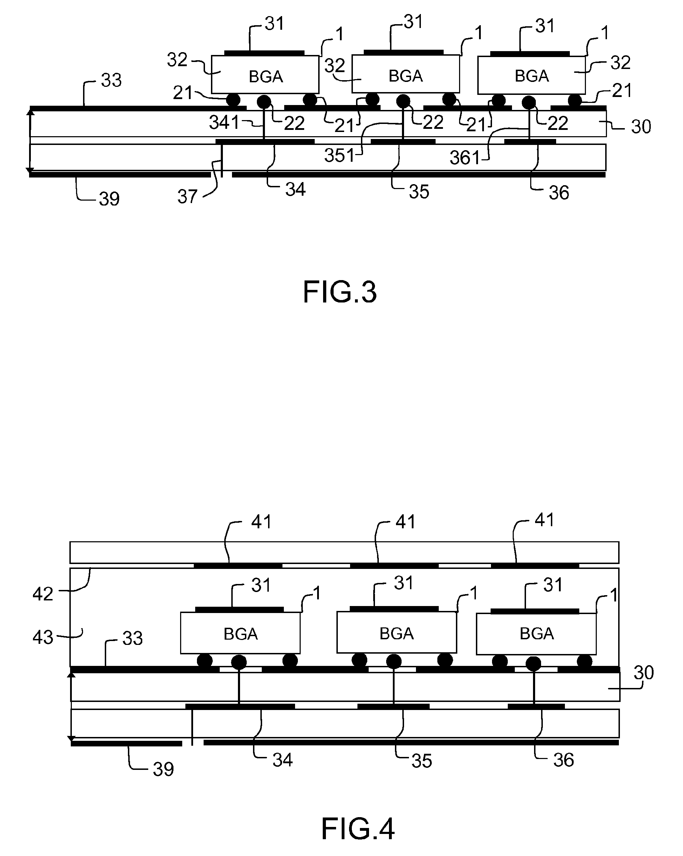

La figure 3 illustre par une vue en coupe un réseau d'éléments rayonnant selon l'invention. Les éléments rayonnant 1 représentés en coupe sont réalisés en technologie BGA comme décrit précédemment et sont implantés sur un circuit imprimé 30. Chaque élément comporte donc une surface rayonnante 31, métallisée, gravée sur le substrat diélectrique 32. Ce dernier comporte en face arrière des billes 21, 22. Les billes de masse 21 sont reliées, par soudure, à un premier plan de masse 33 du circuit imprimé 30. Les billes de signal 22 sont reliées à des pistes internes 34, 35, 36 du circuit imprimé. Les liaisons entre ces billes 22 et les pistes se font par exemple par des lignes conductrices transversales 341, 351, 361 reliant différentes couches du circuit imprimé entre elles. Les lignes de signal 34, 35, 36 sont par exemple reliées à des sources d'alimentation hyperfréquence par des pistes transversales 37. La face externe du circuit imprimé opposée aux éléments rayonnant 1 comporte un deuxième plan de masse 39. La figure 3 illustre un exemple de réalisation simple où le circuit imprimé est de type triplaque, les pistes internes étant réalisées au centre du circuit imprimé.

Les éléments rayonnant 1 disposés en réseau peuvent être implantés suivant une maille triangulaire, comme illustré par la figure 1, ou rectangulaire. La première disposition permet à l'antenne de réaliser un balayage de faisceau avec un angle plus large. Au sein du réseau, les éléments rayonnant 1 sont isolés individuellement les uns des autres, le blindage étant réalisé par les billes de masse 21. A cet effet, les billes de masses sont suffisamment rapprochées les unes des autres.
La construction d'éléments rayonnant selon l'invention par la technologie BGA apporte notamment un autre avantage. En effet, cette construction permet aussi d'introduire du bruit aléatoire au sein d'un réseau d'éléments rayonnant ou d'une antenne comportant un tel réseau. Ceci se traduit par une réalisation avec un pas entre éléments rayonnant très légèrement différent à la fois dans les axes horizontal et vertical du réseau, les éléments rayonnant 1 étant aligné selon un axe horizontal et selon un axe vertical. Ce bruit présente l'avantage de casser les lobes de réseau, qui sont des lobes secondaires parasites, en introduisant ainsi dans l'antenne des erreurs de positionnement aléatoires.

La figure 4 illustre un autre exemple de réalisation possible d'un réseau d'éléments rayonnant selon l'invention. Cet exemple de réalisation, à doubles « patches » permet une utilisation sur une grande bande passante de fréquences. Cette structure comporte une structure du type de la figure 3 sur laquelle est disposée une deuxième structure comportant une deuxième série d'éléments rayonnant 41, les doubles « patches ». Ces éléments rayonnant 41 formés par exemple d'un élément de surface métallique sont alignés avec les éléments rayonnant 1 en technologie BGA. Ces éléments rayonnant 41 sont par exemple gravés sur un substrat diélectrique 42 supporté par une grille métallique ou bien gravés sur un matériau plastique dont la structure permet un alignement constant avec les éléments rayonnant 1 en technologie BGA. L'insertion de la grille métallique 43 peut aller jusqu'au circuit imprimé 30 sur lequel sont soudées les billes 41. Son rôle est notamment de diminuer le couplage entre les éléments rayonnant inférieurs 1, en technologie BGA, et les autres éléments rayonnant, en position supérieure 41. L'ensemble peut être réalisé aisément par encliquetage d'une structure dans l'autre.

Le circuit imprimé 30 peut comporter par ailleurs les fonctions de filtrage, de calibration et de routage des signaux hyperfréquence. Il peut être un simple triplaque diélectrique épais dont la réalisation est standard comme illustré par la figure 3, et le coût faible par rapport à une structure imprimée multicouche à plusieurs niveaux de triplaque. Le fait de disposer d'un circuit triplaque épais permet une très bonne optimisation des pertes diélectriques de transmission et/ou de réception car l'épaisseur peut aller jusqu'à 5 mm notamment qui est généralement l'épaisseur maximale pour des circuits imprimés, contrairement à une structure imprimée multicouche où l'on est contraint d'utiliser une faible épaisseur pour les fonctions de filtre et de routage du fait de l'épaisseur des éléments rayonnant 1 qui peut atteindre 3 mm. De plus ces fonctions sont réalisées par une couche dense et homogène, sans perturbation apportée par d'éventuelles tolérances de fabrication. L'utilisation sur un substrat dont la permittivité est voisine de 3 par exemple rend l'antenne à faible coût. Le circuit triplaque support des éléments rayonnant 1 en technologie BGA est un circuit large bande et permet de disposer des fonctions hyperfréquence avec des pas et une bande différente de celle du réseau.
Un système de calibration intégrant un coupleur hyperfréquence au sein du circuit triplaque 30, coupleur disposé par exemple derrière chaque élément rayonnant 1 ou derrière un groupe d'éléments rayonnant comporte aussi de très faibles pertes. L'utilisation d'un coupleur composé de lignes couplées est avantageuse car les lignes sont larges du fait de l'épaisseur du substrat et du triplaque. Par conséquent, la tolérance de fabrication a un impact de second ordre sur la valeur du couplage, ce qui n'est pas le cas lorsqu'on utilise un substrat fin.

L'utilisation de la technologie BGA appliquée directement aux éléments rayonnant minimise l'interaction entre les éléments rayonnant et les autres fonctions passives telles que par exemple les filtres, les circuits de calibration et de routage. Les performances relatives au TOS, taux d'onde stationnaire actif en dépointage en site et en dépointage en gisement, sont donc optimisées puisque les couplages entre éléments rayonnant au sein de l'antenne ou du réseau d'une part, et ceux entre éléments rayonnant et autres fonctions passives d'autre part sont réduits, les interactions étant minimisées. Les liaisons entre éléments rayonnant et fonctions hyperfréquence sont assurées uniquement par les billes de signal 22, entourées par les billes de masse 21, exactement comme la construction d'un câble coaxiale avec âme centrale et blindage de masse circulaire, les billes de signal 22 correspondant à l'âme centrale et les billes de masse 21 correspondant au blindage circulaire.

Une antenne selon l'invention comporte donc des éléments rayonnant 41 en technologie BGA qui peuvent être directement fixés sur un circuit imprimé qui intègre les autres fonctions hyperfréquence telles que notamment les filtrages passe-bande, les calibrations et le routage des signaux hyperfréquence permettant d'acheminer le signal de la maille d'antenne à la maille des éléments émetteurs ou récepteurs. L'invention a notamment comme avantages :
- de permettre la réalisation d'une antenne ultra-compacte à faible coût ;
- d'atteindre un couplage actif entre éléments rayonnant 1 très faibles, en particulier grâce au double blindage réalisé par les billes de masse en technologie BGA ;
- de disposer d'un réseau d'éléments rayonnant 1 isolés les uns des autres tout en optimisant les pertes du système hyperfréquence passif composé des fonctions de filtrage, calibration et routage.

## Revendications

1. Réseau d'éléments rayonnant, **caractérisé en ce que** les éléments rayonnant (1), sont fixés sur un support (30) selon une connexion à réseau de billes (21, 22) dite BGA, un élément rayonnant comprenant un substrat diélectrique (32) comportant en face avant une surface métallisée (31) et en face arrière deux séries de billes, une première série comportant au moins une bille de signal (22) reliée électriquement à la surface métallisée (31) apte à recevoir un signal hyperfréquence et la deuxième comportant un réseau de billes de masse (31) entourant les billes de la première série, lesdites billes (31) de la deuxième série étant connectées à un plan de masse (33) du support.

2. Réseau selon la revendication 1, **caractérisé en ce que** les billes (31) de masse sont alignées à la périphérie de la face arrière du substrat (32).

3. Réseau selon l'une quelconque des revendications précédentes, **caractérisé en ce que** la distance entre deux billes de masse consécutives (31) est telle que l'ensemble des billes de masse forme un blindage électromagnétique pour les billes de signal (22).

4. Réseau selon l'une quelconque des revendications précédentes, **caractérisé en ce que** le support (30) est un circuit imprimé.

5. Réseau selon l'une quelconque des revendications précédentes, **caractérisé en ce que** les billes de masse (31) étant connectées à un plan de masse (33) du circuit imprimé, les billes de signal (22) sont connectées à une piste interne (34) du circuit imprimé apte à guider un signal hyperfréquence, via une ligne transversale (341).

6. Réseau selon l'une quelconque des revendications 4 ou 5, **caractérisé en ce que** le circuit imprimé (30) est du type triplaque (33, 34, 39).

7. Réseau selon l'une quelconque des revendications 4 à 6, **caractérisé en ce que** le circuit imprimé comporte des composants réalisant des fonctions hyperfréquence appliquées aux signaux transitant par les billes de signal (22).

8. Réseau selon la revendication 7, **caractérisé en ce que** le circuit imprimé comporte les fonctions de filtrage, de calibration et de routage des signaux hyperfréquence vers les éléments rayonnant (1).

9. Réseau selon l'une quelconque des revendications précédentes, **caractérisé en ce que** le réseau d'éléments rayonnant (1) formant une première structure, cette première structure est recouverte d'une deuxième structure comportant des éléments rayonnant (41) sensiblement alignés sur les éléments rayonnant (1) de la première structure.

10. Antenne comportant un réseau selon l'une quelconque des revendications précédentes.
